# EUROPEAN PATENT SPECIFICATION

(11) **EP 2 090 145 B1**
(45) Date of publication and mention of the grant of the patent: **21.05.2014**
(21) Application number: 08735041.9
(22) Date of filing: 04.04.2008
(51) Int. Cl.: H05K 3/38, B32B 7/04, B32B 15/14, B32B 15/20, B32B 27/26, B32B 27/04

(54) **USE OF SILANE COMPOSITIONS FOR THE PRODUCTION OF MULTILAYER LAMINATES**
VERWENDUNG VON SILANVERBINDUNGEN ZUR HERSTELLUNG VON MEHRSCHICHTLAMINATEN
COMPOSITIONS DE SILANE COMPRENANT DE NOUVEAUX AGENTS DE RÉTICULATION

(30) Priority: 04.04.2007 EP 07105660
(43) Date of publication of application: 19.08.2009
(73) Proprietor: Atotech Deutschland GmbH, 10553 Berlin (DE)
(72) Inventor: HÜLSMANN, Thomas, 14167 Berlin (DE); SPARING, Christian, 13509 Berlin (DE); BRUNNER, Heiko, 10247 Berlin (DE); FROESE, Bernd, 12305 Berlin (DE)
(74) Representative: Beckmann, Claus
(86) International application number: PCT/EP2008/002719
(87) International publication number: WO 2008/122427

(56) References cited:
- EP-A- 0 657 394
- EP-A- 0 678 596
- EP-A- 0 756 443
- EP-A- 0 896 502
- WO-A-00/74451
- WO-A-01/19607
- US-A- 5 073 456
- US-A- 5 433 976
- US-A- 5 622 782
- US-A- 6 132 589
- US-A1- 2006 228 470
- US-B1- 6 824 880

## Description

This invention relates to the use of silane compositions, and more particularly to silane compositions comprising crosslinking agents which are not toxic, for the production of multilayer laminates. Thus, the silane compositions are useful as adhesives, and more particularly, as adhesives in the preparation of multi-layer laminates such as printed circuit boards (PCBs).

More particularly, the invention relates to a method for treating an electrically conductive material with a silane composition for the subsequent formation of an adhesive bonding between the conductive surface of the material and a layer of a dielectric material. The treated surfaces show very good bonding properties and exhibit improved moisture resistance.

### BACKGROUND OF THE INVENTION

Silane compositions and silane coupling agents are well known. The use of silane coupling agents can increase the adhesive characteristics of many bonds, particularly the bond of thermosetting resins to glass, metal and metal oxide surfaces. It is well known that the bond formed by silane coupling agents is often deleteriously affected by moisture and, occasionally, the exposure of silane-coupled bonds to humid conditions can lead to the premature failure of the bond.

To minimize the effect that moisture has on silane-coupled bonds, cross-linking agents have been combined with the silane coupling agents. For example, U.S. Patent No. 4,689,085 describes silane compositions which comprise (I) a silane coupling agent; and (II) a disilyl cross-linker compound represented by the general formula

(RO)₃SiR'Si(OR)₃

wherein RO denotes an alkoxy group containing from 1 to 8 carbon atoms, R' is a divalent organic group, and the weight ratio of (I) to (II) is between 1:99 and 99:1 inclusive. The silane compositions are reported to be useful as primers in the production of laminates and other composite materials.

U.S. Patent No. 5,073,456 describes multi-layer printed circuit boards and processes for preparing multi-layer printed circuit boards utilizing a silane bonding mixture consisting essentially of (I) a ureido silane, and (II) a disilyl cross-linking agent generally represented by the formula

(RO)₃SiR'Si(OR)₃

wherein each R is an alkyl group containing 1 to 8 carbon atoms and R' is an alkylene group having from 1 to 8 carbon atoms.

Unfortunately, the disilyl cross-linking agents described in the '085 and '456 patents recently have been found to possess highly toxic properties as disclosed in several TSCA 8(e) submissions to the U.S. Environmental Protection Agency (for example, 8EHQ-0388-0347, 8EHQ-0392-1047, etc.). Therefore, the continued use of disilyl cross-linking agents must be closely examined and materials which can be substituted for the toxic disilyl cross-linking agents would be desirable.

U.S. Patent No. 5,639,555 describes silane compositions which comprise (A) a silane coupling agent; and (B) a tris(silylorgano)amine or alkane represented by the formulae

[(RO)₃SiR¹]₃N

or

[(RO)₃SiR¹]₃CR²

wherein each R is independently an alkyl, alkoxyalkyl, aryl, aralkyl or cycloalkyl group of less than 20 carbon atoms; R¹ is a divalent hydrocarbon or polyether group of less than 20 carbon atoms; and R² is a functional group represented by

CₙH₂ₙX

wherein n is from 0 to 20 and X is selected from the group consisting of amino, amido, hydroxy, alkoxy, halo, mercapto, carboxy, acyl, vinyl, allyl, styryl, epoxy, isocyanato, thiocyanato, isothiocyanato, ureido, thioureido, glycidoxy, and acryloxy groups. The silane compositions are particularly useful as adhesives in preparing multi-layer laminates such as printed circuit boards. These silane compositions do not contain crosslinking agents. Therefore, their adhesion properties are not always sufficient.

US 5,433,976 A describes painted metal sheet pretreated with an insoluble, composite layer containing siloxane. The composite layer is formed by rinsing the sheet with an alkaline solution containing at least 0.005 M of a dissolved silicate or a dissolved aluminate, at least 0.1 vol.-% of an organo-functional silane and at least 0.02 vol.-% of a crosslinking-agent having two or more trialkoxysilyl groups. After the sheet is dried, the composite layer has a thickness of at least 10⁻⁹ m. After being painted, the siloxane forms a tenacious covalent bond between the paint and the metal substrate.

US 2006/228470 A1 describes conversion and passivation coatings and methods for metal surfaces such as steel and aluminum. The coating compositions comprise an aqueous sol of cerium oxide and/or silica particles and a ureido silane compound. The methods comprise contacting the requisite metal surface with the coating composition.

### DESCRIPTION OF THE INVENTION

Therefore, it is an objective of the present invention to provide a method for the production of printed circuit boards, using silane compositions showing excellent adhesion properties while at the same time avoiding the use of toxic components.

This objective is achieved by the method according to claim 1.

The reason for the proviso in claim 1 is that compound (A-4) can act both as coupling as well as crosslinking agent, i.e. it can cross-link itself. Therefore, if compound (A-4) is present, the colloidal silica (B) is not required for cross-linking, but it may still be used as an additional cross-linking agent. If the silane composition does not comprise compound (A-4), then it must comprise the colloidal silica (B). Furthermore, the silane composition must comprise compound (A-1).

The term "colloidal silica" here refers to discrete particles of amorphous silica which are capable of forming stable dispersions or sols. The colloidal silica is preferably employed in the form of such a dispersion or sol. The term excludes polysilicic acid in which the polymer molecules or particles are so small that they do not form stable solutions or dispersions.

The colloidal silica (B) preferably has a particle size in the range of 0.1 to 100 nm, more preferably in the range of 1 to 40 nm, even more preferably in the range of 4 to 22 nm.

In the context of the present invention, preferred alkyl groups contain 1 to 12, preferably 1 to 8, more preferably 1 to 6 carbon atoms. Preferred alkyl groups are methyl, ethyl, propyl, isopropyl and butyl.

In the context of the present invention, preferred alkoxy groups contain 1 to 12, preferably 1 to 8, more preferably 1 to 6 carbon atoms. Preferred alkoxy groups are methoxy, ethoxy, propoxy, isopropoxy and butoxy.

In the context of the present invention, preferred aryl groups contain 6 to 10 carbon atoms. Preferred aryl groups are phenyl and naphthyl.

In the context of the present invention, preferred aralkyl groups contain 7 to 12 carbon atoms. A preferred aralkyl group is benzyl.

In the context of the present invention, preferred alkenyl groups contain 2 to 12, preferably 2 to 6 carbon atoms. Preferred alkenyl groups are vinyl and allyl.

X according to formula A-1 is preferably selected from the groups represented by the formulas 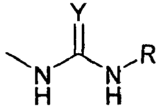 wherein Y = O, S or NR¹, wherein R and R¹ are independently hydrogen, alkyl, aryl, aralkyl, allyl or alkenyl;
and 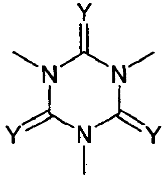 wherein Y = O, S or NR², wherein R² is hydrogen or an alkyl group having 1 to 20, preferably 1 to 8 carbon atoms.

A in formula A-1 is preferably selected from the group consisting of methoxy, ethoxy, propoxy, isopropoxy, butoxy and hydroxy.

Preferred compounds of formula (A-1) are 3-aminopropyltrimethoxysilane, ureidopropyltriethoxysilane, aminopropylsilantriol, N-(3-triethoxysilylpropyl)gluconamide and 3-glycidoxypropyltrimethoxysilane.

Preferred compounds of formula (A-4) are sodium silicate and Na₆Si₂O₇.

The silane compositions used according to the present invention may contain each of the combinations of compounds (A-1), (A-4) and (B) shown in the following table, wherein "X" indicates that the compound is present and "(x)" indicates that the compound may or may not be present.

| **Combination** | A-1 | A-4 | B |
|---|---|---|---|
| 1 | X | | X |
| 2 | X | X | (x) |

It is an advantage of the present invention that the use of toxic crosslinking agents as for example according to U.S. Patent No. 5,639,555 can be avoided.

Furthermore, the silane compositions used according to the present invention show very good solubility in organic solvents as well as water-based solutions and exhibit very good adhesion properties. In addition the silane compositions used according to the present invention show higher long-term stability than the silane compositions of the state of the art, because they are more stable to hydrolysis. Thus, undesired precipitation of decompositions products can be avoided.

Most coupling agents contained in the silane composition used according to the present invention are known as such and are commercially available.

As described in U.S. Patent No. 5,101,055, the tris(silylorgano)amines may be prepared from the corresponding bis-amine by contacting the bis-amine with particulate palladium monoxide at a temperature within the range of from about 50 °C to 300 °C. Another procedure for preparing the tris(silylorgano)amine compounds utilizes the reaction of the bis(trialkoxysilyl-alkyl)amine with an equimolar amount of a trialkylsilylpropyl halide such as the chloride and is described in U.S. Patent No. 4,775,415.

A procedure for preparing novel coupling agents according to formula A-1 is described in the examples.

The silane compositions used according to the present invention may comprise other materials such as solvents, fillers, etc. Solvents should be capable of solubilizing both the silane coupling agent (A) and the crosslinking agent (B). Typically, such solvents include lower alcohols such as methanol, ethanol, butanol or isopropanol. Suitable solvents also include Glycols like ethylene glycol, propylene glycol, butyl glycol and glycol ethers like ethylene glycol monoethyl ether, ethylene glycol monobutyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutyl ether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether, tripropylene glycol monobutyl ether, diethylene glycol monoisopropyl ether, propylene glycol monomethyl ether acetate and diethylene glycol monobutyl ether.

Water, or mixtures of water and alcohols can also be used as a solvent. It is reported in the state of the art (U.S. Patent No. 5,639,555) that the stability of water-based solutions is generally more limited than the solutions made with alcohols. Compositions used according to the present invention are much more stable also in water-based solutions, which can be considered another advantage of the present invention.

Small portions of water can be added to the silane compositions in order to hydrolyze the silane coupling agent (A) and crosslinking agent (B). Alternatively, dispersions or emulsions of the silane compositions can be prepared in suitable organic solvent or mixtures of water and organic solvent. Typical solvents include, in addition to the alcohols described above, ethers, ketones, aliphatic and aromatic hydrocarbons, amides such as N,N-dimethylformamide, etc. Aqueous emulsions of the silane-coupling agents can be prepared in the conventional manner using conventional dispersants and surfactants, including nonionic surfactants.

The silane compositions used according to the present invention are preferably aqueous solutions or dispersions; preferably, the aqueous solutions or dispersions are free of organic solvents.

The pH value of the silane compositions is preferably in the range of 3 to 11, more preferably in the range of 4 to 9 and even more preferably in the range of 5 to 6.

The content of compounds (A) and (B) in the silane compositions may vary from 100% by weight in pure mixtures to as little as 0.1 weight percent or less in very dilute solutions or emulsions. Preferred compositions contain 0.001 to 2 mol/l of the silane coupling agent (A) and the crosslinking agent (B), even more preferred 0.03 to 0.1 mol/l.

The expression "compounds (A)" refers to the totality of all compounds of formulae (A-1) and (A-4) that are contained in the silane compositions used according to the present invention.

Generally, the molar ratio of compounds (A) : compound (B) is in the range of 99 : 1 to 1 : 99, preferably in the range of 10 : 1 to 1 : 4.

A wide range of fillers can be included in the silane compositions used according to the present invention. The fillers may be particulate or fibrous fillers, and these include siliceous materials such as glass, quartz, ceramic, asbestos, silicone resin, glass fibers, and nano fillers, metals such as aluminum, steel, copper, nickel, magnesium and titanium, metal oxides such as magnesium oxide, iron oxide, and aluminum oxide, and metal fibers and metal-coated glass fibers. The amount of the filler included in the silane compositions may range from 0 to about 10% by weight. When the filler is present, it is more often present in amounts of from about 0.1 to about 3% or 4% by weight.

According to the present invention, the silane compositions are utilized as adhesives in a wide variety of composite materials. In practice, the silane compositions may be applied as a liquid solution or emulsion to one surface of the two surfaces to be bonded, or the silane compositions can be applied to both of the surfaces to be bonded together. The silane compositions, particularly solutions and emulsions, can be applied to the surfaces by any conventional means such as by dipping, spraying, brushing, immersion, etc.

In one embodiment, the silane compositions are useful for bonding a thermosetting resin surface to another resin surface which may be composed of a thermosetting resin, a thermosetting resin surface to glass, a thermosetting resin surface to metal, etc. The silane compositions enhance the bond or peel strength between joined surfaces. A possible application includes the manufacture of resin coated copper foils (RCC), composed of a dielectric layer and a copper foil.

In one embodiment, the silane compositions are useful in preparing multi-layer laminates including printed circuit boards (PCBs).

Typical multi-layer laminates will comprise
(a) at least one insulating layer,
(b) at least one additional layer which may be insulating or electrically conductive, and
(c) an adhesion-promoting layer of the silane composition as defined above positioned between and adhered to the aforementioned two layers.

Other multilayer laminates may comprise
(a) at least one layer of an electrically conductive material;
(b) at least one layer of a dielectric material; and
(c) an adhesion-promoting layer of the silane composition as defined above positioned between and adhered to said conductive material and said dielectric material.

Yet further multilayer laminates may comprise
(a) at least one dielectric layer having a conductive metal coating or metal circuitry on at least one surface;
(b) at least one insulating layer; and
(c) a silane layer between the surface of the dielectric layer having a conductive metal coating or metal circuitry and the insulating layer wherein said silane layer is formed from the silane compositions as defined above.

The adhesion-promoting layer of the silane composition enhances the bond or peel strength between the layer of conductive material (e.g., copper) and the layer of dielectric material.

Useful dielectric substrates or layers may be prepared by impregnating woven glass reinforcement materials with partially cured resins, usually epoxy resins (e.g., difunctional, tetrafunctional and multifunctional epoxies). Epoxy resins are particularly suited. It is an advantage of the silane compositions used according to the present invention that they show very good adhesion on both glass and resin areas of the substrate material, which is often a problem with compositions known from the prior art.

Examples of useful resins include amino-type resins produced from the reaction of formaldehyde and urea, or formaldehyde and melamine, polyesters, phenolics, silicones, polyamides, polyimides, di-allyl phthalates, phenyl silanes, polybenzimidazoles, diphenyloxides, polytetrafluoroethylenes, cyanate esters, etc. These dielectric substrates often are referred to as prepregs. An epoxy substrate of the newest generation is Ajinomoto GX-3 and GX-13, which contains glass ball fillers and can also be treated with the silane composition. This kind of substrate is particularly suited for SBU technique.

The insulating layer and the dielectric layer can be prepared by impregnating woven glass reinforcement materials with partially cured resins as described above. Thus, the insulating layer or layers also may be prepregs.

In the formation of multi-layer laminates and circuit boards, several dielectric layers having a conductive metal coating or metal circuitry on at least one surface and several insulating layers may be employed.

In one example of a multi-layer laminate, the laminate can contain in order, a dielectric layer (prepreg), copper foil or copper circuitry on at least one surface of the dielectric layer, a layer of a silane composition as defined above and an insulating layer of a thermosetting resin. Conductive metal coating or metal circuitry may be a copper sheet or foil or a copper circuitry coated with a layer of tin or an oxide or hydroxide of tin. The conductive metal sheets or foils and metal circuitry can be applied to the dielectric layer by techniques well known to those skilled in the art. The silane compositions defined above are particularly suitable for circuitries with fine line resist structures possessing high-density interconnect (HDI) feature sizes of 50 µm and even 25 µm or lower.

The metal circuitry on the dielectric layer may be obtained by conventional techniques such as by a photoimage technique of a photosensitive resist film followed by etching of the unprotected areas of metal on the dielectric layer to form electrically conductive paths or electrically conductive patterns. Etching processes are well known, and examples are described in, for example, U.S. Patents Nos. 3,469,982 and 5,017,271.

The metal coating or metal circuitry on the dielectric layer may be coated with a thin outer layer of a metal such as tin. This layer which is of a thickness generally not greater than 1.5 µm and preferably in the range of 0.05 to 0.2 µm can be formed by immersion metal plating using e.g., commercial tin-plating solutions. During and subsequent to the application of the tin, a thin coating of an oxide, hydroxide or combination thereof is formed.

A second silane adhesion-promoting layer can then be applied over the etched pattern using the techniques described above, and a second prepreg is adhered to the etched pattern. The second adhesion-promoting layer is positioned between and adhered to both the etched pattern and the second prepreg. The techniques for making multilayer circuit boards also are well known in the art.

The multi-layer laminates prepared as described above may be subjected to conventional laminating temperatures and pressures between plates of laminating presses. In this manner, the laminating operation generally will involve pressures in the range of from about 1.72 MPa (250 psi) to about 5.17 MPa (750 psi), temperatures in the range of from about 130 °C to about 350 °C and laminating cycles of from about 30 minutes to about 2 hours. The finish laminates can then be utilized in a variety of applications including printed circuit boards.

The advantages of the silane compositions used according to the present invention include enhanced adhesion, enhanced oxidation resistance and enhanced moisture resistance.

### EXAMPLES

### PREPARATION EXAMPLE 1:

### Preparation of a novel coupling agent of formula A-1: 1-Methyl-3-(3-trimethoxysilyl-propyl)-thiourea

A 250 mL reaction flask is charged with 10 g (54.1 mmol) (3-amino-propyl)-trimethoxysilane, 4.04 g (54.1 mmol) methylisothiocyanate and 100 mL dry dioxane. The reaction mixture is heated for 20 hours at refluxing and cooled to room temperature. After completion of the reaction, the solvent is removed under vacuum. The obtained oil is the desired product which is homogeneous and slightly brown in color.

### PREPARATION EXAMPLE 2:

### Preparation of a novel coupling agent of formula A-1: 1-(2-Dimethylamino-ethyl)-3-(3-trimethoxysilyl-propyl)-thiourea

A 250 mL reaction flask is charged with 12.5 g (69.9 mmol) (3-amino-propyl)-trimethoxysilane, 9.1 g (69.9 mmol) 2-N,N-dimethylamino-ethylisothiocyanate and 200 mL dry dioxane. The reaction mixture is stirred for 20 hours at room temperature. After completion of the reaction, the solvent is removed under vacuum. The obtained oil (20.9 g; yield: 96.6%) is the desired product which is homogeneous and slightly brown in color.

### TEST EXAMPLES:

The improved adhesion obtained with the silane compositions used according to the present invention is demonstrated by conducting a pull strength test performed in accordance with IPC-TM-650 No 2.4.8. In the test, a copper foil of the type Gould GTC (7.5 x 15 cm), copper thickness 35 µm is cleaned, etched and coated with an immersion tin solution for 30 seconds and at a temperature of 35 °C in a dip mode. The immersion tin solution is commercially available (Secure Enhancer process, Atotech Deutschland GmbH). Alternatively to the dip mode, a spray mode can also be applied.

The copper foil is then immersed at room temperature in a 0.03 mol/l solution in methanol of the silane composition as specified in Tables 1 to 4. Adjustment to a pH of 3.8 with acetic acid is performed in some cases. The immersion time is between 1 and 2 minutes. Thereafter, a sponge roller is applied to the thus treated surface to obtain a silane layer of uniform thickness.

Post baking at elevated temperatures in an oven as specified in the tables is optional, but not required for good adhesion. The post baking is performed at a temperature of 50 to 200 °C, preferably 80 to 120 °C and for a period of time of 30 to 120 minutes.

The thus silane coated foil is laminated to FR4 Prepreg (Isola 104ML) using a vacuum assisted press (HML multilayer press) heated to 175 °C and adjusted to press at 2.07 MPa (300 psi) for 80 minutes.

Following the pressing cycle, the laminated foils are air-cooled to room temperature for 75 minutes.

The pull test is performed in accordance with IPC-TM-650 No 2.4.8. The results are the combined average strengths of the adhesive bonds in N/cm. The results of the pull strength test are summarized in Tables 1 to 5.

Table 1 shows peel strength values for silane compositions comprising tetraethoxy silane as a crosslinking agent.

As can be seen from the table, the peel strength values after dipping for 1 to 2 minutes vary from 11.7 N/cm to 13.4 N/cm. In general, values higher than 10 N/cm can be considered very good for production of multilayer printed circuit boards.

It is an advantage of the present invention that no thermal treatment after applying the silane composition is required compared to the state of the art, e.g. U.S. Patent No. 5,639,555 or European Patent Application No. 0 310 010, in order to achieve good adhesion values.

Table 2 shows peel strength values for silane compositions comprising colloidal silica as crosslinking agent. Again, very good adhesion values can be obtained. Silicon dioxide is particularly preferred as a crosslinking agent because it is least toxic and cheapest compared to the other crosslinking agents known from the state of the art.

Table 3 shows adhesion values for silane compositions comprising colloidal silica, however with a smaller particle size of 3 to 5 nm compared to the silicon dioxide referred to in Table 2. Again, very good adhesion values are obtained.

Table 4 shows adhesion values for silane compositions comprising sodium silicate as crosslinking agent. The compositions are alkaline in pH. The pH value is determined by the pH of the sodium silicate applied and usually ranges from 9 to 12.

As described above, sodium silicate can be both the silane coupling agent as well as the crosslinking component. However for sodium silicate alone adhesion values are lower than for the two-component compositions and are therefore less preferred for most applications.

Table 5 shows adhesion values for silane compositions comprising a coupling agent according to formula (A-1). Composition No. 6 is included for comparison.

In Tables 1 and 2, the entry "without" under "pH" means "without control", i.e. that the pH was not controlled.

**Table 1: Adhesion tests results for silane compositions comprising tetraalkoxysilanes**

| No. | Composition (molar ratio) | Exposition Conditions (Time / Rinsing) | | | | Baking Conditions (Time / Temperature) | | | | pH |
|---|---|---|---|---|---|---|---|---|---|---|
| | | 1 min with rinsing | 2 min with rinsing | 1 min without rinsing | 2 min without rinsing | 30 min 100 °C | 60 min 100 °C | 30 min 150 °C | 60 min 150 °C | |
| 1 | Ureidopropyltriethoxysilane / Tetraethoxysilane (50:50) | 8.0 | 7.5 | 13.6 | 13.1 | 12.9 | 13.5 | 13.9 | 13.2 | 3.8 |
| 2 | Ureidopropyltriethoxysilane / Tetraethoxysilane (90:10) | 12.0 | 11.5 | 13.1 | 12.9 | 13.1 | 13.3 | 13.5 | 13.4 | without |
| 3 | 3-Aminopropyltrimethoxysilane / Tetraethoxysilane (50:50) | 10.3 | 11.3 | 12.9 | 12.6 | 12.3 | 13.3 | 13.2 | 12.3 | 3.8 |
| 4 | 3-Aminopropyltrimethoxysilane / Tetraethoxysilane (90:10) | 13.0 | 12.6 | 11.5 | 11.9 | 12.8 | 13.3 | 12.5 | 13.0 | without |
| 5 | Ureidopropyltriethoxysilane / Tetraethoxysilane (25:75) | 9.5 | 9.8 | 13.1 | 12.8 | 12.8 | 12.9 | 13.5 | 12.9 | 3.8 |
| 6 | 3-Aminopropyltrimethoxysilane / Tetraethoxysilane (25:75) | 9.5 | 9.7 | 12.8 | 11.9 | 12.8 | 12.5 | 12.2 | 12.0 | 3.8 |
| 7 | Tetraethoxysilane (100%) | 9.6 | 9.3 | 10.5 | 11.7 | 10.5 | 10.8 | 12.4 | 11.7 | 3.8 |
| 8 | N-(3-triethoxysilylpropyl)gluconamide / Tetraethoxysilane (50:50) | 10.7 | 10.5 | 13.6 | 13.4 | 13.0 | 13.8 | 13.8 | 13.4 | 3.8 |
| 9 | Ureidopropyltriethoxysilane / Tetraisopropoxysilane (50:50) | 8.3 | 9.4 | 12.3 | 13.1 | 12.9 | 11.7 | 12.7 | 12.3 | without |

| | | | | | | | | | | |
|---|---|---|---|---|---|---|---|---|---|---|
| Except in column "pH", the values given are peel strengths in N/cm. | | | | | | | | | | |

**Table 2: Adhesion tests results for silane compositions comprising colloidal silica (20 to 22 nm)**

| No. | Composition (molar ratio) | Exposition Conditions (Time / Rinsing) | | | | Baking Conditions (Time / Temperature) | | | | pH |
|---|---|---|---|---|---|---|---|---|---|---|
| | | 1 min with rinsing | 2 min with rinsing | 1 min without rinsing | 2 min without rinsing | 30 min 100 °C | 60 min 100 °C | 30 min 150 °C | 60 min 150 °C | |
| 1 | Ureidopropyltriethoxysilane / colloidal silica (50:50) | 7.2 | 8.8 | 12.7 | 12.5 | 12.8 | 12.2 | 12.6 | 12.9 | 3.8 |
| 2 | Ureidopropyltriethoxysilane / colloidal silica 40% in H₂O (90:10) | 11.1 | 12.4 | 13.0 | 12.2 | 13.5 | 12.6 | 12.3 | 13.9 | without |
| 3 | 3-Aminopropyltrimethoxysilane / colloidal silica (90:10) | 11.9 | 8.4 | 13.2 | 12.5 | 12.8 | 12.9 | 11.9 | 12.8 | 3.8 |
| 4 | 3-Aminopropyltrimethoxysilane / colloidal silica (50:51) | 12.3 | 12.0 | 10.0 | 10.3 | 12.3 | 12.2 | 11.3 | 11.6 | without |

| | | | | | | | | | | |
|---|---|---|---|---|---|---|---|---|---|---|
| Except in column "pH", the values given are peel strengths in N/cm. | | | | | | | | | | |

**Table 3: Adhesion tests results for silane compositions comprising colloidal silica (4 to 5 nm)**

| No. | Composition (molar ratio) | Exposition Conditions (Time / Rinsing) | | | | Baking Conditions (Time / Temperature) | | | | pH |
|---|---|---|---|---|---|---|---|---|---|---|
| | | 1 min with rinsing | 2 min with rinsing | 1 min without rinsing | 2 min without rinsing | 30min 100 °C | 60min 100 °C | 30 min 150 °C | 60 min 150 °C | |
| 1 | Ureidopropyltriethoxysilane / colloidal silica (1:1) | 7.9 | 7.3 | 12.5 | 12.8 | 11.9 | 11.8 | 13.3 | 12.5 | 6 |
| 2 | 3-Glycidoxypropyltrimethoxysilane / colloidal silica (1:1) | 5.9 | 6.0 | 10.7 | 10.4 | 11.3 | 10.6 | 12.4 | 11.4 | 6 |
| 3 | 3-Aminopropyltrimethoxysilane / colloidal silica (1:1) | 11.1 | 11.9 | 12.6 | 11.2 | 12.3 | 12.9 | 12.4 | 12.4 | 9 |
| 4 | N-(3-Triethoxysilylpropyl)gluconamide / colloidal silica (1:1) | 7.5 | 7.5 | 10.9 | 10.1 | 9.4 | 10.5 | 10.5 | 11.4 | 5 |
| 5 | Aminopropylsilantriol / colloidal silica (1:1) | 10.6 | 11.9 | 12.2 | 12.3 | 12.6 | 12.3 | 12.5 | 11.6 | 9 |
| 6 | Tetraethoxysilane / colloidal silica (1:1) | 8.6 | 8.1 | 8.5 | 8.7 | 8.3 | 9.0 | 8.5 | 8.6 | 3.8 |

| | | | | | | | | | | |
|---|---|---|---|---|---|---|---|---|---|---|
| Except in column "pH", the values given are peel strengths in N/cm. | | | | | | | | | | |

**Table 4: Adhesion tests results for silane compositions comprising sodium silicate (Crystal 79)**

| No. | Composition (molar ratio) | Exposition Conditions (Time / Rinsing) | | | | Baking Conditions (Time / Temperature) | | | | pH |
|---|---|---|---|---|---|---|---|---|---|---|
| | | 1 min with rinsing | 2 min with rinsing | 1 min without rinsing | 2 min without rinsing | 30 min 100 °C | 60 min 100 °C | 30 min 150 °C | 60 min 150 °C | |
| 1 | Ureidopropyltriethoxysilane / Sodium Silicate (1:1) | 8.2 | 8.2 | 13.0 | 12.4 | 11.8 | 12.4 | 13.1 | 13.6 | 11 |
| 2 | 3-Glycidoxypropyltrimethoxysilane / Sodium Silicate (1:1) | 8.1 | 7.3 | 11.0 | 11.6 | 11.0 | 11.6 | 11.2 | 12.8 | 11 |
| 3 | 3-Aminopropyltrimethoxysilane / Sodium Silicate (1:1) | 12.3 | 11.6 | 11.8 | 11.2 | 12.3 | 12.7 | 12.8 | 12.8 | 11 |
| 4 | N-(3-Triethoxysilylpropyl)gluconamide / Sodium Silicate (1:1) | 6.7 | 6.9 | 12.4 | 12.6 | 12.0 | 12.2 | 12.0 | 12.5 | 11 |
| 5 | Aminopropylsilantriol / Sodium Silicate (1:1) | 11.5 | 11.4 | 11.5 | 12.7 | 12.2 | 12.9 | 11.7 | 12.7 | 4.1 (stab.) |
| 6 | Sodium Silicate (1:1) | 6.9 | 6.7 | 8.4 | 9.1 | 8.8 | 9.1 | 7.7 | 8.8 | 11 |
| 7 | Tetraethoxysilane / Sodium Silicate (1:1) | 7.8 | 6.1 | 8.8 | 8.5 | 8.5 | 8.8 | 8.8 | 8.7 | 11 |

| | | | | | | | | | | |
|---|---|---|---|---|---|---|---|---|---|---|
| Except in column "pH", the values given are peel strengths in N/cm. | | | | | | | | | | |

**Table 5: Comparison of crosslinking agents**

| No. | Composition (molar ratio) | Exposition Conditions (Time / Rinsing) | |
|---|---|---|---|
| | | 1 min with rinsing | 2 min with rinsing |
| 1 | Ureidopropyltriethoxysilane / Tetraethoxysilane (1:1) | 13.6 | 13.1 |
| 2 | Ureidopropyltriethoxysilane / Tetraisopropoxysilane (1:1) | 12.3 | 13.1 |
| 3 | Ureidopropyltriethoxysilane / colloidal silica (20 to 22 nm) (1:1) | 12.7 | 12.5 |
| 4 | Ureidopropyltriethoxysilane / colloidal silica (4 to 5 nm) (1:1) | 12.5 | 12.8 |
| 5 | Ureidopropyltriethoxysilane / Na₆Si₂O₇ (1:1) | 13 | 12.4 |
| 6* | DuraBond-Process according to US 5,073,456 (Ureidopropyltriethoxysilane / Bis(trimethoxysilyl)ethane (1:1)) | 12.1 | 12.4 |

| | | | |
|---|---|---|---|
| The values given are peel strengths in N/cm. *For comparison. | | | |

## Claims

1. A method for the production of printed circuit boards, comprising a step of treating an electrically conductive material for the subsequent formation of an adhesive bonding between the conductive material and a layer of a dielectric material by bringing the surface of the electrically conductive material into contact with a solution containing a silane composition comprising at least one coupling agent selected from the group consisting of
(A-1) a silane coupling agent **characterized by** the formula
A₍₄₋ₓ₎SiBₓ (A-1)
wherein
each A is independently a hydrolyzable group, e.g. a hydroxy or alkoxy group,
x is 1 to 3, and
each B is independently a C₁-C₂₀ alkyl or aryl group or a functional group represented by the formula
CₙH₂ₙX,
wherein
n is from 0 to 20, preferably 0 to 12, more preferably 1 to 12, even more preferably 1 to 8, most preferably 1, 2, 3, 4, 5, 6 or 7 and
X is selected from the group consisting of amino, amido, hydroxy, alkoxy, halo, mercapto, carboxy, carboxy ester, carboxamide, thiocarboxamide, acyl, vinyl, allyl, styryl, epoxy, glycidoxy, isocyanato, thiocyanato, thioisocyanato, ureido, thioureido, guanidino, thioglycidoxy, and acryloxy groups; or X is a residue of a carboxy ester, a carboxamide or a thiocarboxamide of a carbohydrate;
(A-4) a water soluble silicate coupling agent **characterized by** the formula
SiO₂ • x M₂O (A-4)
wherein
x is 1 to 4, and
M is an alkali metal or ammonium ion; and
(B) a colloidal silica **characterized by** the formula
(SiO₂)ₙ; (B)
with the proviso that
(a) said colloidal silica (B) is optional if compound (A-4) is present,
(b) said colloidal silica (B) is mandatory if compound (A-4) is not present, and
(c) the silane composition comprises compound (A-1).

2. The method according to claim 1, wherein X according to formula A-1 is selected from the groups represented by the formulas 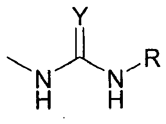 wherein Y = O, S or NR¹, wherein R and R¹ are independently hydrogen, alkyl, aryl, aralkyl, allyl or alkenyl;
and 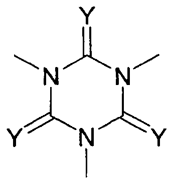 wherein Y = O, S or NR², wherein R² is hydrogen or an alkyl group having 1 to 20, preferably 1 to 8 carbon atoms.

3. The method according to any of the foregoing claims, wherein A in formula A-1 is selected from the group consisting of methoxy, ethoxy, propoxy, isopropoxy, butoxy and hydroxy.

4. The method according to any of the foregoing claims, wherein x in formula A-4 is 1 to 3.

5. The method according to any of the foregoing claims, wherein the colloidal silica according to formula B has a particle size in the range of 0.1 to 100 nm, preferably from 1 to 40 nm.

6. The method according to any of the foregoing claims, wherein the molar ratio of compounds (A) : compound (B) is in the range of 99 : 1 to 1 : 99, preferably in the range of 10 : 1 to 1 : 4.

7. The method according to any of the foregoing claims, wherein the pH value of the silane composition is in the range of 3 to 11.

8. The method according to any of the foregoing claims, wherein the silane composition is an aqueous solution free of organic solvents.

9. Use of a silane composition as defined in any of claims 1 to 8 for the production of printed circuit boards.

10. A printed circuit board comprising
(a) at least one layer of an electrically conductive material;
(b) at least one layer of a dielectric material; and
(c) an adhesion-promoting layer of a silane composition as defined in any of claims 1 to 8 positioned between and adhered to said conductive material and said dielectric material.

11. The printed circuit board of claim 10 wherein the conductive metal coating or metal circuitry comprises a copper coating or copper circuitry coated with tin, tin oxide or tin hydroxide.

## Patentansprüche

1. Verfahren zur Herstellung von Leiterplatten, umfassend eine Stufe des Behandelns eines elektrisch leitenden Materials zur nachfolgenden Bildung einer klebenden Verbindung zwischen dem leitenden Material und einer Schicht eines dielektrischen Materials durch Inkontaktbringen der Oberfläche des elektrisch leitenden Materials mit einer Lösung, enthaltend eine Silanzusammensetzung, umfassend mindestens ein Kupplungsmittel, ausgewählt aus der Gruppe, bestehend aus
(A-1) einem Silankupplungsmittel, das **gekennzeichnet ist durch** die Formel
A₍₄₋ₓ₎SiBₓ (A-1)
worin
A jeweils unabhängig eine hydrolysierbare Gruppe, z.B. eine Hydroxy- oder Alkoxygruppe, ist
x 1 bis 3 ist und
B jeweils unabhängig eine C₁-C₂₀-Alkyl- oder Arylgruppe oder eine funktionelle Gruppe der Formel
CₙH₂ₙX
ist, worin
n 0 bis 20, bevorzugt 0 bis 12, mehr bevorzugt 1 bis 12, noch mehr bevorzugt 1 bis 8, am meisten bevorzugt 1, 2, 3, 4, 5, 6 oder 7 ist und
X ausgewählt ist aus der Gruppe, bestehend aus Amino-, Amido-, Hydroxy-, Alkoxy-, Halogen-, Mercapto-, Carboxy-, Carboxyester-, Carboxamid-, Thiocarboxamid-, Acyl-, Vinyl-, Allyl-, Styryl-, Epoxy-, Glycidoxy-, Isocyanato-, Thiocyanato-, Thioisocyanato-, Ureido-, Thioureido-, Guanidino-, Thioglycidoxy- und Acryloxygruppen; oder X ein Rest eines Carboxyesters, eines Carboxamids oder eines Thiocarboxamids eines Kohlenhydrats ist;
(A-4) einem wasserlöslichen Silicatkupplungsmittel, das **gekennzeichnet ist durch** die Formel
SiO₂ • x M₂O (A-4)
worin
x 1 bis 4 ist und
M ein Alkalimetall- oder Ammoniumion ist; und
(B) einem kolloidalen Siliciumdioxid, das **gekennzeichnet ist durch** die Formel
(SiO₂)ₙ; (B)
mit der Maßgabe, dass
(a) das kolloidale Siliciumdioxid (B) optional ist, falls die Verbindung (A-4) vorhanden ist,
(b) das kolloidale Siliciumdioxid (B) zwingend ist, falls die Verbindung (A-4) nicht vorhanden ist, und
(c) die Silanzusammensetzung die Verbindung (A-1) umfasst.

2. Verfahren nach Anspruch 1, wobei X gemäß Formel A-1 ausgewählt ist aus den Gruppen der Formeln 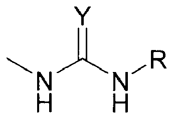 worin Y = O, S oder NR' ist, worin R und R¹ unabhängig voneinander Wasserstoff, Alkyl, Aryl, Aralkyl, Allyl oder Alkenyl sind;
und 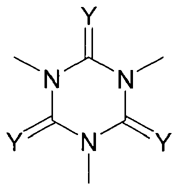 worin Y = O, S oder NR² ist, worin R² Wasserstoff oder eine Alkylgruppe mit 1 bis 20, bevorzugt 1 bis 8, Kohlenstoffatomen ist.

3. Verfahren nach einem der voranstehenden Ansprüche, wobei A in Formel A-1 ausgewählt ist aus der Gruppe, bestehend aus Methoxy, Ethoxy, Propoxy, Isopropoxy, Butoxy und Hydroxy.

4. Verfahren nach einem der voranstehenden Ansprüche, wobei x in Formel A-4 1 bis 3 ist.

5. Verfahren nach einem der voranstehenden Ansprüche, wobei das kolloidale Siliciumdioxid gemäß Formel B eine Teilchengröße im Bereich von 0,1 bis 100 nm, bevorzugt von 1 bis 40 nm aufweist.

6. Verfahren nach einem der voranstehenden Ansprüche, wobei das molare Verhältnis von Verbindung (A) : Verbindung (B) im Bereich von 99 : 1 bis 1: 99, bevorzugt im Bereich von 10 : 1 bis 1 : 4 liegt.

7. Verfahren nach einem der voranstehenden Ansprüche, wobei der pH-Wert der Silanzusammensetzung im Bereich von 3 bis 11 liegt.

8. Verfahren nach einem der voranstehenden Ansprüche, wobei die Silanzusammensetzung eine wässrige Lösung ist, die frei von organischen Lösungsmitteln ist.

9. Verwendung einer Silanzusammensetzung, wie sie in einem der Ansprüche 1 bis 8 definiert ist, zur Herstellung von Leiterplatten.

10. Leiterplatte, umfassend
(a) mindestens eine Schicht eines elektrisch leitenden Materials;
(b) mindestens eine Schicht eines dielektrischen Materials; und
(c) eine haftungsverstärkende Schicht einer Silanzusammensetzung, wie sie in einem der Ansprüche 1 bis 8 definiert ist, die zwischen dem leitenden Material und dem dieletrischen Material angeordnet ist und diesen anhaftet.

11. Leiterplatte nach Anspruch 10, wobei die Beschichtung aus leitendem Metall oder die metallische Schaltung eine Kupferbeschichtung oder eine Kupferschaltung umfasst, die mit Zinn, Zinnoxid oder Zinnhydroxid beschichtet ist.

## Revendications

1. Procédé de production de cartes de circuit imprimé, comprenant une étape de traitement d'un appareil électriquement conducteur pour la formation ultérieure d'une liaison par adhésif entre le matériau conducteur et une couche d'un matériau diélectrique par pontage de la surface du matériau électriquement conducteur en contact avec une solution contenant une composition de silane comprenant au moins un agent de couplage au silane choisi dans le groupe consistant en
(A-1) un agent de couplage de silane **caractérisé par** la formule
A₍₄₋ₓ₎SiBₓ (A-1)
dans laquelle
chaque A est indépendamment un groupe hydrolysable, par exemple, un groupe hydroxy ou un groupe alcoxy,
x vaut 1 à 3, et
chaque B est indépendamment un groupe alkyle en C₁ à C₂₀ ou aryle ou un groupe fonctionnel représenté par la formule
CₙH₂ₙX,
dans laquelle
n vaut de 0 à 20, de préférence 0 à 12, de manière davantage préférée 1 à 12, de manière encore davantage préférée 1 à 8, de manière préférée entre toutes 1, 2, 3, 4, 5, 6 ou 7 et
X est choisi dans le groupe consistant en les groupes amino, amido, hydroxy, alcoxy, halogéno, mercapto, carboxy, carboxy ester, carboxamide, thiocarboxamide, acyle, vinyle, allyle, styryle, époxy, glycidoxy, isocyanato, thiocyanato, thioisocyanato, uréido, thiouréido, guanidino, thioglycidoxy et acryloxy ; ou X est un résidu d'un carboxy ester, un carboxamide ou un thiocarboxamide d'un glucide ;
(A-4) un agent de couplage au silicate soluble dans l'eau **caractérisé par** la formule
SiO₂ •x M₂O (A-4)
dans laquelle
x vaut 1 à 4, et
M est un ion de métal alcalin ou ammonium ; et
(B) une silice colloïdale **caractérisée par** la formule
(SiO₂)ₙ ; (B)
aux conditions que
(a) ladite silice colloïdale (B) soit facultative si le composé (A-4) est présent,
(b) ladite silice colloïdale (B) soit obligatoire si le composé (A-4) n'est pas présent, et
(c) la composition de silane comprenne le composé (A-1).

2. Procédé selon la revendication 1, dans lequel X selon la formule A-1 est choisi parmi les groupes représentés par les formules 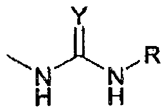 dans laquelle Y = 0, S ou NR¹, où R et R¹ sont indépendamment hydrogène, alkyle, aryle, aralkyle, allyle ou alcényle ;
et 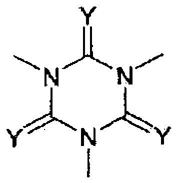 dans laquelle Y = 0, S ou NR², où R² est un hydrogène ou un groupe alkyle comportant 1 à 20, de préférence 1 à 8 atomes de carbone.

3. Procédé selon l'une quelconque des revendications précédentes, dans lequel A dans la formule A-1 est choisi dans le groupe consistant en méthoxy, éthoxy, propoxy, isopropoxy, butoxy et hydroxy.

4. Procédé selon l'une quelconque des revendications précédentes, dans lequel x dans la formule A-4 vaut 1 à 3.

5. Procédé selon l'une quelconque des revendications précédentes, dans lequel la silice colloïdale selon la formule B a une taille de particule dans la plage de 0,1 à 100 nm, de préférence de 1 à 40 nm.

6. Procédé selon l'une quelconque des revendications précédentes, dans lequel le rapport molaire composés (A) : composé (B) est dans la plage de 99 : 1 à 1 : 99, de préférence dans la plage de 10 : 1 à 1 : 4.

7. Procédé selon l'une quelconque des revendications précédentes, dans lequel la valeur de pH de la composition de silane est dans la plage de 3 à 11.

8. Procédé selon l'une quelconque des revendications précédentes, dans lequel la composition de silane est une solution aqueuse dépourvue de solvants organiques.

9. Utilisation d'une composition de silane telle que définie dans l'une quelconque des revendications 1 à 8, pour la production de cartes de circuit imprimé.

10. Carte de circuit imprimé comprenant
(a) au moins une couche d'un matériau électriquement conducteur ;
(b) au moins une couche d'un matériau diélectrique ; et
(c) une couche favorisant l'adhérence d'une composition de silane telle que définie dans l'une quelconque des revendications 1 à 8, positionnée entre lesdits et mise à adhérer auxdits matériau conducteur et matériau diélectrique.

11. Carte de circuit imprimé selon la revendication 10, dans laquelle le revêtement de métal conducteur ou la circuiterie de métal comprend un revêtement de cuivre ou une circuiterie de cuivre revêtu d'étain, d'oxyde d'étain ou d'hydroxyde d'étain.
